# EUROPEAN PATENT SPECIFICATION

(11) **EP 3 875 184 B1**
(45) Date of publication and mention of the grant of the patent: **28.01.2026**
(21) Application number: 19879589.0
(22) Date of filing: 18.09.2019
(51) Int. Cl.: B21D 37/01, B21D 22/28, B21D 51/26, C23C 16/26

(54) **PRESS DIE AND PRESSING METHOD**
PRESSWERKZEUG UND PRESSVERFAHREN
OUTIL DE PRESSAGE ET PROCÉDÉ DE PRESSAGE

(30) Priority: 31.10.2018 JP 2018204896
(43) Date of publication of application: 08.09.2021
(73) Proprietor: Toyo Seikan Group Holdings, Ltd., Shinagawa-ku Tokyo 141-8627 (JP)
(72) Inventor: KUMAGAI, Takuho, Yokohama City Kanagawa 240-0062 (JP); SHIROISHI, Ryozo, Yokohama City Kanagawa 240-0062 (JP); OGAWA, Tomohiro, Yokohama City Kanagawa 240-0062 (JP); MATSUMOTO, Naoya, Yokohama City Kanagawa 240-0062 (JP); SHIMAMURA, Masahiro, Yokohama City Kanagawa 240-0062 (JP)
(74) Representative: Dehns
(86) International application number: PCT/JP2019/036582
(87) International publication number: WO 2020/090271

(56) References cited:
- WO-A1-2017/033791
- WO-A1-2018/193524
- JP-A- 2000 006 979
- JP-A- 2004 001 034
- JP-A- 2004 141 917
- JP-A- 2005 305 510
- JP-A- 2009 286 852
- JP-A- 2018 158 354
- JP-A- H11 267 769

## Description

### [Technical Field]

The present invention relates to a pressing die and a press working method, and more particularly, to a pressing die and a working method for the pressing die suitable for shaping a can made of, for example, aluminum.

### [Background Art]

In the past, press working has been used as a manufacturing method for manufacturing industrial products at a low cost and in a mass. Such press working is suitable for working various work materials, and as an example of such work material, not only metal materials of, for example, steel, copper, and aluminum but also titanium, magnesium and so forth can be exemplified.

As an example of such an industrial product as described above, for example, a can material can be exemplified. For example, in a can material configured from two pieces exemplified in PTL 1, a can body part and so forth are shaped by drawing and ironing work using such a pressing die as described above.

On the other hand, a pressing die that performs press working includes a punch part and a die part, and a work material is press shaped in a state in which the punch part and the die part are spaced from each other with an appropriate clearance interposed therebetween.

Since, in press working, the punch part and the die part are placed in a harsh environment, it has been proposed to coat a working surface of a die with a diamond film or a carbon film such as a DLC (Diamond-Like Carbon) film as disclosed, for example, in PTL 2 to PTL 5.

[PTL 1]
   Japanese Patent No. 6012804
[PTL 2]
   Japanese Patent Laid-Open No. 2013-163187
[PTL 3]
   Japanese Patent Laid-Open No. Hei 10-137861
[PTL 4]
   Japanese Patent Laid-Open No. Hei 11-277160
[PTL 5]
   Japanese Patent Laid-Open No. Hei 1-306023
[PTL 6]
   WO 2017/033791 A1, on which the preamble of independent claims 1 and 5 is based, describes a die for ironing working.

### [Summary]

### [Technical Problems]

Since a pressing die is placed in a harsh working environment as described above, such a measure as, for example, to coat a working surface of the die part with various surface treatment films is generally taken. For such a surface treatment film, it is desirable that a material that has a high sliding characteristic and can suppress adhesion upon pressing by the work material is selected suitably and that the working surface is coated specifically with such a carbon film as a diamond film or a DLC film.

However, according to the existing technologies including the pieces of Patent Literature described above, the subject described below remains unsolved and the room for improvement is still great.

In particular, for example, in the can material described above, thinning of the can body part has been and is in progress in recent years, and from such a background as just described, also for a pressing die, severe clearance management and working durability are demanded.

However, if a DLC film is formed, for example, on the die part or the punch part of a pressing die, then it is undeniable that it cannot withstand press working that is performed repeatedly and therefore has difficulty in working durability. On the other hand, if a diamond film is formed on the die part or the punch part in a pressing die, then although this is desirable in that superior working durability is obtained, the member coated with the diamond film is difficult in dimension control and is not suitable for severe management of the clearance.

Taking it consideration to solve the problems described above as an example, it is an object of the present invention to provide a pressing die and a press working method that can achieve both facilitation of management of an appropriate clearance and working durability at a high level.

### [Solution to Problems]

In order to achieve the object described above, the pressing die of the present invention is a pressing die as defined in independent claim 1.

It is to be noted that, preferably the surface treatment film is diamond-like carbon having a Vickers hardness of 1000 to 8000 Hv.

Further, in the pressing die above, preferably the die part is coated with the diamond film, and the punch part is coated with the surface treatment film.

Further, in the pressing die according to any one of the preferred aspects above, preferably the metal material is a can material, and drawing and ironing working for forming at least a can body part is performed using the punch and the die.

Further, in order to achieve the object described above, there is also provided a press working method comprising the features of independent claim 5.

It is to be noted that, in the press working method according to above, preferably the metal material is press worked so as to make a can body part by the punch part and the die part through coolant.

It is to be noted that, in the press working method according to any aspect above, preferably an oil content in the coolant is equal to or lower than 4.0 volume percent.

### [Advantageous Effect of Invention]

According to the present invention, since a diamond film and a surface treatment film of 8000 Hv or less, which are different in hardness from each other, are individually coated on the punch part and the die part, while adjustment of the clearance is facilitated by the surface treatment film having a relatively low hardness, also high working durability can be implemented simultaneously.

### [Brief Description of Drawings]

[FIG. 1]

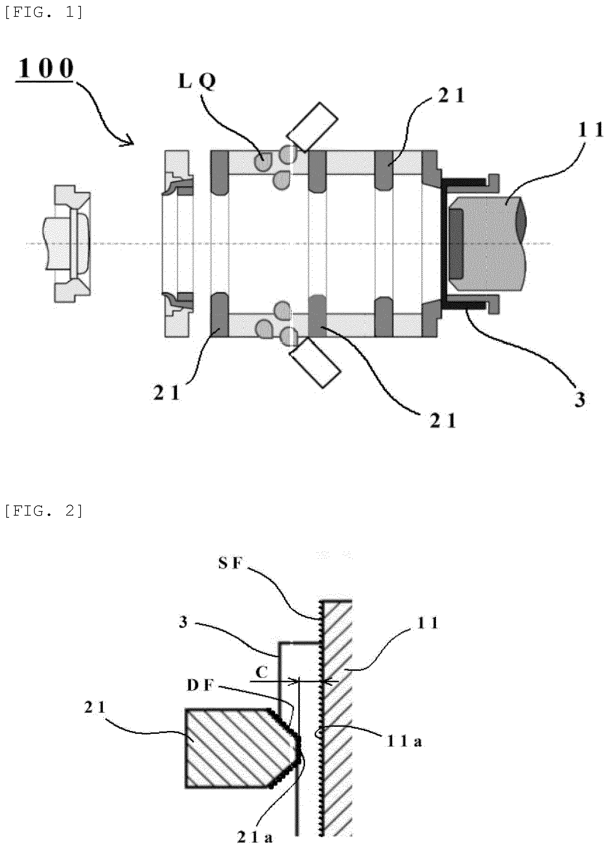

   FIG. 1 is a schematic view of a pressing die according to an embodiment.
[FIG. 2]
   FIG. 2 is a schematic view depicting a state when a metal material as a work material is press worked.

### [Description of Embodiment]

In the following, a pressing die and a press working method of the present invention are described particularly with reference to the drawings suitably.

### <Pressing Die>

First, a pressing die 100 of an embodiment is described with reference to FIGS. 1 and 2.

As depicted in FIG. 1 and so forth, the pressing die 100 is configured such that it has a function of press working a metal material and includes a punch part 11 and die parts 21 for ironing working.

It is to be noted that the press working in the present embodiment includes, for example, shaping pressing such as a mode of drawing working (Draw work) a metal material, a mode of performing ironing working (Ironing work), a mode of drawing and ironing working (DI work) and so forth.

Although the following description is given taking ironing working of shaping a metal material into a can body, the application of the present invention is not limited to such press working of a can body, and the present invention can also be applied to a mode of performing ironing working of a metal material into a different shape such as that of a photosensitive drum.

Although the metal material as a work material in the present embodiment is not specifically limited as long as it is used for press working, not only various known metal materials such as, for example, aluminum, iron, steel, copper, and titanium but also alloy materials of them, clad materials, pre-coated materials having an organic resin or the like layered thereon and so forth can be applied. In order to shape a can body, among the metal materials described above, aluminum is especially suitable.

In ironing working for forming a can body part from a metal material 3, press working (in this case, ironing working) is performed by the punch part 11 in a state in which the metal material 3 of a drawn cup having been worked into a flange state in a preceding step is interposed between a die part 21 and the punch part 11 as depicted in FIG. 1 and so forth.

A clearance C between a side face 11a of the punch part 11 and a distal end facing face 21a of the die part 21 at this time is finally set, although this differs depending upon a procedure or a product, for example, in the case of an aluminum can for beverage, to approximately 100 µm, and a permissible error range in this case is only ± several µm (for example, 2 to 5 µm). In addition, in a case where a can body is press worked, for example, from a metal material as described above, also high working durability sufficient to withstand mass production is required.

Therefore, in the pressing die 100 of the present embodiment, the working surface of one of the punch part 11 and the die part 21, which surface contacts with the metal material 3, is covered with a diamond film DF, and the working surface of the other of the punch part 11 and the die part 21, which surface contacts with the metal material 3, is coated with a surface treatment film SF of a Vickers hardness equal to or lower than 8000 Hv.

Such a pressing die 100 as described above can be used suitably at least in ironing working of forming a can body part from a can material as a work material.

In the following, significance of the present invention that uses the diamond film DF and the surface treatment film SF of 8000 Hv or less in the present embodiment is described.

First, since it is supposed that press working is performed basically in a harsh working environment, for example, at least the working surface of the die part that contacts with a work material is sometimes coated with a surface treatment film for the object of reduction in friction and of durability impartation. In this regard, from the point of view of film formation or hardness, utilization of a DLC is examined in recent years as exemplified in PTL 2 and so forth.

Here, many existing technologies including those of the pieces of Patent Literature described hereinabove pay attention to the die part on which relatively high load is imposed. In the meantime, in mass production at the time of practical use, abrasion or damage such as adhesion of a work material appears also on the punch part although such abrasion or damage is minor in comparison with that on the die part. Thus, taking stabilized formability or durability of the die into consideration, it can be considered desirable that some surface treatment film is coated also on the punch part side.

Taking also such a point of view as just described into consideration, in the present embodiment, a surface treatment film is coated on the working surfaces of both the punch part 11 and the die parts 21. Thus, for a combination of surface treatment films of the punch part 11 and the die parts 21, patterns indicated in Table 1 below can be supposed.

**[Table 1]**

| | One tool | The other tool |
|---|---|---|
| Pattern A | Cemented carbide material (no coating) | Cemented carbide material (no coating) |
| Pattern B | Cemented carbide material (no coating) | DLC film |
| Pattern C | Cemented carbide material (no coating) | Diamond film |
| Pattern D | DLC film | DLC film |
| Pattern E | Diamond film | Diamond film |
| Pattern F | DLC film | Diamond film |

First, the pattern A is examined.

The combination of the pattern A is a case in which a surface treatment film is not formed, and this is carried out also by press working that uses lubricant such as, for example, coolant. It is to be noted that, as regards the "one tool" and "the other tool," it is described in the following description that the "one tool" is the punch part 11 and "the other tool" is the die parts 21. However, the present invention is not restricted to this example, and a reverse configuration may be applied such that the "one tool" is the die parts 21 or the like.

For example, in ironing working in a can manufacturing procedure, also the pressing die 100 is placed in a severe working environment as described hereinabove. In this case, it can be imagined easily that, every time pressing is performed, such various problems as abrasion and seizure or adhesion and deposition of work materials occur with each tool.

In regard to such a subject as just described, also in the pattern B or the pattern C in which a surface treatment film is formed on the other tool, a similar subject occurs at least with the side of the one tool for which a coating process is not performed.

Accordingly, in order to maintain the working quality and suppress abrasion and seizure of the tools, it is necessary for the working surfaces of the "one tool" and "the other tool" to be coated with a surface treatment film.

Although, in this regard, the pattern D and the pattern E can surely ensure the abrasion resistance and the seizure resistance to some degree, a problem described below is not solved as yet.

In particular, also in a case where a DLC film is formed on the "one tool" and "the other tool" as indicated by the pattern D, although the abrasion resistance and so forth are enhanced in comparison with those in the case of no coating, in the first place, it is difficult to form a thick DLC film from its characteristic. Thus, there is room for improvement in durability.

Further, since both tools are substantially same in hardness, for example, if the tools collide with each other from some reason, then it cannot be predicted which one of them is damaged, and there is some concern that this may increase damage by break.

Further, even in regard to the pattern E, there similarly is a concern of increase of damage by break described above, and besides, the diamond film has problems arising from its nature. For example, adjustment in dimension is very difficult from such reasons, for example, that the temperature upon film formation is high and a change in dimension of a base material is caused by such high temperature, that there is a dispersion in formed film thickness (film thickness) by increase in thickness, that the hardness is high and easy polishing cannot be anticipated, and so forth. Further, dimension management between the dies is difficult, which makes a cause of increase of the cost. As described above, also in ironing working in can manufacture, in a situation in which dimension management of ± several µm is required, it is not realistic to apply the combination of the pattern E.

Therefore, in the present embodiment, the working surface of the punch part 11 that is the "one tool" is coated with a DLC film as the surface treatment film SF, and the working surface of the die parts 21 that are "the other tool" is coated with the diamond film DF.

It is to be noted that, although the "one tool" is the punch part 11 and "the other tool" is the die parts 21 as described above, such a reverse combination that the die parts 21 are coated with a DLC film as the surface treatment film SF and the punch part 11 is coated with the diamond film DF may be applied. However, generally the die parts 21 are acted upon by harsher working load than that upon the punch part 11, and from such a point as just described, it is preferable to coat the die parts 21 with the diamond film DF and coat the punch part 11 with a DLC film as the surface treatment film SF in order to enhance the working durability as a whole.

In the following, the individual films are described in detail.

### <Diamond Film DF>

As depicted in FIG. 2, the diamond film DF of the present embodiment is formed on the working surface of the die part 21 (face contacting with the metal material 3 as a work material).

Although there is no limitation to a formation method of such a diamond film DF as just described as long as the diamond film DF can be formed, known formation methods such as, for example, a mode that uses a chemical vapor deposition (CVD) method or a mode that uses physical vapor deposition (PVD) can be applied.

Here, to the thickness of the diamond film DF, a thickness within a reasonable range formed on the basis of the known method described above can be applied. The thickness of such a diamond film DF as just descried preferably is approximately 5 to 30 µm as an example.

It is to be noted that, although it is sufficient if the diamond film DF is formed at least on the working surface described above of the die part 21, it may be formed otherwise at a different portion.

Further, according to the invention, the Vickers hardness of the diamond film DF is 10000 to 12000 Hv.

### <Surface Treatment Film SF>

Meanwhile, as depicted in FIG. 2, the surface treatment film SF in the present embodiment is formed on the working surface of the punch part 11 (face contacting with the metal material 3 as the work material).

The surface treatment film SF in the present embodiment is a surface treatment film set such that the hardness thereof is relatively lower than that of the diamond film DF described above. Such a surface treatment film SF as just described preferably is a DLC film having a Vickers hardness of 1000 to 8000 Hv.

Further, among such DLC films as described above, a hydrogen-free DLC film that does not contain hydrogen is preferable in the present embodiment. This is because, since such a hydrogen-free DLC film (DLC film having a tetrahedral amorphous carbon structure) has a hardness of, for example, approximately a Vickers hardness of 6000 Hv, it is high in working durability and the compatibility with the diamond film DF that is paired upon press working is good.

The formation method of such a DLC film as just described is not restricted specifically, and known formation methods such as, for example, a CVD method by which gas is used as a raw material and is decomposed in a chamber to form a film and a PVD method by which solid carbon is used as a raw material and the carbon is evaporated to form a film can be applied.

Also in regard to the thickness of the surface treatment film SF, a thickness within a reasonable range formed on the basis of such known methods as described above can be applied, and preferably the thickness is approximately 0.1 to 10 µm as an example. In particular, the thickness of the surface treatment film SF is set such that it is smaller than the thickness of the diamond film DF. By adopting such a configuration as just described, it is possible to enjoy such advantages as described below. In particular, since the surface treatment film SF having the thickness described above is a film thinner than the diamond film DF, first of all, the dimension error by film formation is small. In addition, since the Vickers hardness of the surface treatment film SF is 8000 Hv or less and the surface treatment film SF is soft in comparison with the diamond, the surface treatment film SF can be polished easily by using known diamond abrasive grain, and not only the working cost can be reduced but also the targeted dimension of the die can be finished with high accuracy.

It is to be noted that, although it is sufficient if the diamond film DF is formed at least on the above-described working surface of the die part 21, it may otherwise be formed on a different portion.

Further, although a diamond-like carbon film is used as the surface treatment film SF in the present embodiment, the surface treatment film SF is not specifically restricted as long as the Vickers hardness of the surface treatment film (SF) is 8000 Hv or less and the subject described above can be achieved, and other surface treatment films such as, for example, a TiC film having a Vickers hardness of approximately 3200 to 3800 Hv or a TiCN film of approximately 3000 to 3500 Hv may be used.

### <Press Working Method>

Now, a press working method suitable for ironing working of forming a can body part of a seamless can body in the present embodiment is described.

In the present embodiment, a press working method of press working a metal material 3 of aluminum or the like, by using the punch part and the die part, is characterized in that the work surface, which contacts with the metal material, of one of the punch part and the die part is coated with a diamond film and that the working surface, which contacts with the metal material, of the other of the punch part and the working surface is coated with a surface treatment film of a Vickers hardness equal to or lower than 8000 Hv.

It is to be noted that, although an example of application to ironing working in a can manufacturing procedure of a seamless can body is described below, the present invention is not restricted to the ironing work application.

In particular, the present invention may be applied similarly to the working surface (face contacting with the metal material 3) of a blanking punch part and a blanking die part in blanking working not depicted and may be applied to the working surface (face contacting with the metal material 3) of a drawing working punch part, a drawing working die part, and a wrinkle holding jig in ironing work.

At this time, at least in press working in the ironing working described above, preferably a metal material as the work material is press worked such that it is made a seamless can body by the punch part 11 and the die parts 21 through coolant LQ (refer to FIG. 1).

It is to be noted that, as the coolant LQ, various known liquids can be applied as long as lubrication application and cooling of the die upon pressing are achieved. Although liquids containing oil among components are listed especially favorably, otherwise a coolant that does not contain oil may be used, and, for example, water such as pure water may be used as the coolant. It is to be noted that, if working is performed using such coolant that contains a comparatively small amount of oil, then the lubricity becomes insufficient. Therefore, in the case of an ordinary die made of a cemented carbide, the work material suffers from seizure to the surface of the die, resulting in failure in good working. In contrast, where a die coated with such a diamond film or a DLC film as described above is used, the surface treatment for them described above is low in reactive property with soft material, especially with aluminum, and is superior in seizure resistance. Therefore, also where coolant that contains less oil like water is used, shaping can be performed without a problem. By using such coolant as just described, the used amount of degreaser such as detergent or drug that is used in a succeeding cleaning step can be reduced. Further, since the wastewater treatment is superior, in a case where wastewater recycling or the like is performed, reduction of the amount of waste water can be anticipated, and reduction of the wastewater amount, and as a result, reduction of the environmental load, becomes possible.

As the oil in the coolant LQ in the present embodiment, oil contained in a general water-soluble metalworking oil composition is available. The oil may be natural oil or synthetic oil.

As the natural oil, for example, paraffin-based, naphthenic-based, aromatic-based and like mineral oils are available. Also fatty acid glyceride is available as the natural oil.

As the synthetic oil, for example, hydrocarbonbased oil such as polyolefin, ester-based oil such as fatty acid ester, ether-based oil such as polyalkylene glycol, fluorine-containing oil such as perfluorocarbon, phosphorus-containing oil such as phosphate, siliconcontaining oil such as silicate ester and so forth are available.

The oils listed above may be used alone or two or more of them may be used as mixture.

It is to be noted that, as the water-soluble metalworking oil composition, for example, water-soluble metalworking oil compositions of the A1 type (emulsion type), A2 type (soluble type), and A3 type (solution type) prescribed in JIS K 2241 are available.

Further, though not prescribed in the JIS standard, also a water-soluble metalworking oil composition called synthetic type (metalworking oil composition that does not contain mineral oil but contains chemically synthesized oil) is available.

In the present embodiment, preferably the concentration of the oil in the coolant LQ is equal to or lower than 4.0 volume percent. In this case, where the coolant LQ containing oil is used in the present embodiment, coolant in which the concentration of oil is equal to or lower than 4.0 volume percent may be prepared by preparing undiluted liquid containing oil of a content exceeding 4.0 volume percent first and storing it until it is used and then diluting, when it is to be used, the undiluted liquid with solvent such as water.

In particular, it is sufficient if the concentration of oil in the coolant LQ in a use state is equal to or lower than 4.0 volume percent.

Further, as components other than the oil in the coolant LQ, components that are contained in a general water-soluble metalworking oil composition, for example, water, surfactant, rust preventive agent, extremepressure additive, coupling agent, non-ferrous metal corrosion inhibitor, preservative, deformer, chelating agent, coloring material, flavoring agent or the like may be contained suitably.

In this manner, in ironing working of a seamless can body in the present embodiment, press working may be carried out by the punch part 11 and the die part 21 in a state in which the coolant LQ intervenes.

For example, where the metal material 3 is aluminum, aluminum powder is sometimes produced by press working, and this aluminum powder causes a defect by sticking to the die or a shaped article. In contrast, according to the present embodiment, since ironing working of a seamless can body is performed in a state in which the coolant LQ intervenes, it is possible to appropriately remove such aluminum powder produced in such working as described above.

It is to be noted that the present invention can be applied not only to press working in which the coolant LQ described above intervenes but also press working in a dry environment in which no coolant intervenes. However, in the case of press working in such a dry environment as just described, in order to cool working heat generated by pressing, it is necessary to provide a cooling pipe or the like in the inside of the die. This complicates the overall apparatus. In addition, since degradation of strength of the work material is caused by the working heat, there is the possibility also that the working limitation may become lower. From those reasons, in the present embodiment, although improvement of the working durability is anticipated even in a dry environment in which no coolant intervenes, it is considered more preferable to perform working in a state in which coolant intervenes.

### Working Examples

### <Working Example 1>

Using the pressing die 100 described in deal in connection with the embodiment, ironing working was performed to form a can body (seamless can body) having a can body part using a metal material (drawn cup) 3 after drawing worked. It is to be noted that, in the working example 1, at the time of ironing working, water was used as the coolant LQ, or a can body having a can body part was shaping worked without the intervention of the coolant LQ.

In the shaping work, as the surface treatment film SF coated on the working surface of the punch part 11, a hydrogen-free DLC film (of a Vickers hardness of approximately 6000 Hv) was formed to a thickness of 1 µm by a known physical vapor deposition method (AIP (Arc Ion Plating) method) (film thickness: 1 µm).

In the meantime, the diamond film DF coated on the working surface of the die parts 21 was formed to a thickness of approximately 10 µm by a known chemical vapor deposition method (thermal filament method).

The ironing working in the working example 1 was performed by a hydraulic press after a previous step described below was performed.

First, an aluminum plate (A3004) of a plate thickness of 0.29 mm was punched by a known crank press, and a shallow drawn cup of φ95 mm was obtained through ironing working.

Then, the resulting shallow drawn cup was set to the blank holder of the hydraulic press, and the punch part 11 was moved at a speed of 1 m/s to perform working. As a more detailed working process, re-drawing of φ66 mm was performed first, and through immediate three times of ironing working, a can body of a plate thickness of 100 µm was obtained finally.

At this time, the ironing punch and the blank holder that serve as the male die (punch part 11 side) were coated with the DLC film described above, and the drawing dice and the ironing dice that serve as the female die (die parts 21 side) were coated with the diamond film described hereinabove.

Working of 100 cans was performed successively by the working method described above, and adhesion of aluminum to the punch part 11 and the die parts 21 was checked visually.

This visual evaluation was performed in accordance with the following criteria.

AAA: adhesion of aluminum to the punch part 11 and the die parts 21 was not viewed.

BBB: adhesion of aluminum to at least one of the punch part 11 and the die parts 21 was visually confirmed.

CCC: collapse occurred during working and a can body was not obtained.

### <Working Example 2>

A can body having a can body part was shaping worked similarly as in the working example 1 except that no coolant intervened upon ironing working.

### <Comparative Example 1>

A can body having a can body part was shaping worked similarly as in the working example 1 except that the drawing dice and the ironing dice that serve as the female die (die parts 21 side) were coated with the DLC film same as that on the male die (punch part 11 side).

### <Comparative Example 2>

A can body having a can body part was shaping worked similarly as in the working example 1 except that a cemented carbide having no surface treatment performed therefor was used for the punch and the blank holder that serve as the male die (punch part 11 side).

### <Comparative Example 3>

A can body having a can body part was shaping worked similarly as in the working example 1 except that a cemented carbide having no surface treatment performed therefor was used for the punch and the blank holder that become the male die (punch part 11 side) and the drawing dice and the ironing dice that become the female die (die parts 21 side) were coated with the DLC film described above.

### <Comparative Example 4>

A can body having a can body part was shaping worked similarly as in the working example 1 except that a cemented carbide having no surface treatment performed therefor was used for both the punch and the blank holder that become the male die (punch part 11 side) and the drawing dice and the ironing dice that become the female die (die parts 21 side).

### <Comparative Example 5>

A can body having a can body part was shaping worked similarly as in the working example 1 except that a cemented carbide having no surface treatment performed therefor was used for both the punch and the blank holder that become the male die (punch part 11 side) and the drawing dice and the ironing dice that become the female die (die parts 21 side) and further that emulsion is used as the coolant.

Surface treatment specifications and evaluation results of the working examples 1 and 2 and the comparative examples 1 to 5 described above are indicated in Table 2.

**[Table 2]**

| | Punch part 11 | Die part 21 | Coolant presence (Type) | Evaluation | |
|---|---|---|---|---|---|
| | | | | Result | Remarks |
| Working example 1 | DLC film | Diamond film | Present (water) | AAA | |
| Working example 2 | DLC film | Diamond film | Absent | AAA | |
| Comparative example 1 | DLC film | DLC film | Present (water) | BBB | Adhere to die part |
| Comparative example 2 | Cemented carbide | Diamond film | Present (water) | BBB | Adhere to punch part |
| Comparative example 3 | Cemented carbide | DLC film | Present (water) | BBB | Adhere to both punch part and die part |
| Comparative example 4 | Cemented carbide | Cemented carbide | Present (water) | CCC | Not shapeable |
| Comparative example 5 | Cemented carbide | Cemented carbide | Present (emulsion) | AAA | |

The results in Table 2 are described.

First, the comparative example 5 is based on conditions of general DI working in which the surface treatment for the die is not performed and emulsion that contains oil by 4.0 volume percent or more is used as the coolant.

Also in this comparative example 5, as the number of manufactured cans increases, abrasion is observed on both the punch part 11 and the die parts 21. However, at the level of several tens cans, there is no significant problem and working can be performed.

On the other hand, if the coolant is changed to water that contains oil by 4.0 volume percent or less as seen in the comparative example 4 changed from the comparative example 5, then the lubricity becomes insufficient and collapse occurs, resulting in failure to obtain a can body.

In regard to the comparative examples 2 and 3, where the diamond film is coated only on the die parts 21 side as described also in the pieces of Patent Literature described hereinabove (comparative example 2), since reduction in friction on the die parts 21 side on which working is severe becomes possible, a can body is obtained for the time being. However, in such a working condition as described above, adhesion of aluminum to the punch part 11 side for which surface treatment was not performed is observed after shaping of the level of several tens cans, which results in appearance of damage to the can inner face. Therefore, as the number of manufactured cans increases, the adhesion range increases, and it is supposed that collapse of the body occurs eventually.

Further, where the DLC film is used for the die parts 21 side as in the comparative example 3, although working itself is possible, the seizure resistance is insufficient on the die parts 21 side on which working is severe, and arising from this, adhesion of aluminum to the die appears.

The comparative example 1 is a case in which the DLC film is applied to both the punch part 11 side and the die parts 21 side, and also in such a working condition as just described, adhesion of aluminum to the die parts 21 side is observed, and although working on the level of several tens cans is possible, as the number of manufactured cans increases, the adhesion range increases. Thus, it is supposed that collapse of the body occurs eventually.

In contrast, with the configurations of the working examples indicated by the working examples 1 and 2, adhesion of aluminum is not observed on any of the punch part 11 side and the die parts 21 side. In short, it was proved that not only they are superior in working durability but also working is possible without a problem even in an environment in which oil is less.

The embodiment and the working examples described above can be modified in various manners without departing from the subject matter of the present invention.

### [Industrial Applicability]

The present invention can be used suitably for a pressing die specifically for which both excellent abrasion resistance and reduction of the die management cost can be achieved.

### [Reference Signs List]

- 100:: Pressing die
- 11:: Punch part
- 21:: Die part
- 3:: Metal material (work material)

## Claims

1. A pressing die (100) for press working a metal material (3) using a punch part (11) and a die part (21), wherein
a working surface of one of the punch part (11) and the die part (21) is coated with a diamond film (DF), and the working surface contacting with the metal material (3), **characterized in that**:
a working surface of the other one of the punch part (11) and the die part (21) is coated with a surface treatment film (SF) having a Vickers hardness of 8000 Hv or less, the working surface contacting with the metal material (3);
a thickness of the surface treatment film (SF) is thinner than a thickness of the diamond film (DF); and
a Vickers hardness of the diamond film (DF) is 10000 to 12000 Hv.

2. The pressing die according to claim 1, wherein
the surface treatment film (SF) is diamond-like carbon having a Vickers hardness of 1000 to 8000 Hv.

3. The pressing die according to claims 1 or 2,
wherein
the die part (21) is coated with the diamond film (DF), and the punch part (11) is coated with the surface treatment film (SF).

4. The pressing die according to any one of claims 1 to 3, wherein
the metal material (3) is a can material, and drawing and ironing working for forming at least a can body part is performed using the punch part (11) and the die part (21).

5. A press working method for press working a metal material (3) using a punch part (11) and a die part (21), wherein
a working surface of one of the punch part (11) and the die part (21) is coated with a diamond film (DF), the working surface contacting with the metal material (3), **characterized in that**
a working surface of the other one of the punch part (11) and the die part (21) is coated with a surface treatment film (SF) having a Vickers hardness of 8000 Hv or less, the working surface contacting with the metal material (3);
a thickness of the surface treatment film (SF) is thinner than a thickness of the diamond film (DF); and
a Vickers hardness of the diamond film (DF) is 10000 to 12000 Hv.

6. The press working method according to claim 5, wherein
the metal material (3) is press worked so as to make a can body part by the punch part (11) and the die part (21) through coolant (LQ).

7. The press working method according to claim 5 or 6, wherein
an oil content in the coolant (LQ) is equal to or lower than 4.0 volume percent.

## Patentansprüche

1. Presswerkzeug (100) zum Pressformen eines Metallmaterials (3) unter Verwendung eines Stempelteils (11) und eines Matrizenteils (21), wobei
eine Arbeitsfläche eines der Stempelteile (11) oder des Matrizenteils (21) mit einem Diamantfilm (DF) beschichtet ist und die Arbeitsfläche mit dem Metallmaterial (3) in Kontakt steht, **dadurch gekennzeichnet, dass**:
eine Arbeitsfläche des jeweils anderen Stempelteils (11) und des Matrizenteils (21) mit einem Oberflächenbehandlungsfilm (SF) beschichtet ist, der eine Vickershärte von 8.000 Hv oder weniger aufweist, wobei die Arbeitsfläche mit dem Metallmaterial (3) in Kontakt steht;
eine Dicke des Oberflächenbehandlungsfilms (SF) dünner ist als eine Dicke des Diamantfilms (DF); und
eine Vickershärte des Diamantfilms (DF) von 10.000 bis 12.000 Hv beträgt.

2. Presswerkzeug nach Anspruch 1, wobei
die Oberflächenbehandlungsfilm (SF) besteht aus diamantähnlichem Kohlenstoff und weist eine Vickershärte von 1.000 bis 8.000 Hv auf.

3. Presswerkzeug nach Anspruch 1 oder 2, wobei
der Matrizenteil (21) mit dem Diamantfilm (DF) beschichtet ist und der Stempelteil (11) mit dem Oberflächenbehandlungsfilm (SF) beschichtet ist.

4. Presswerkzeug nach einem der Ansprüche 1 bis 3, wobei
das Metallmaterial (3) ein Dosenmaterial ist, und eine Zieh- und Abstreckbearbeitung zum Formen mindestens eines Dosenkörperteils unter Verwendung des Stempelteils (11) und des Matrizenteils (21) durchgeführt wird.

5. Pressbearbeitungsverfahren zum Pressformen eines Metallmaterials (3) unter Verwendung eines Stempelteils (11) und eines Matrizenteils (21), wobei
eine Arbeitsfläche eines der Stempelteile (11) und des Matrizenteils (21) mit einem Diamantfilm (DF) beschichtet ist und die Arbeitsfläche mit dem Metallmaterial (3) in Kontakt steht, **dadurch gekennzeichnet, dass**
eine Arbeitsfläche des jeweils anderen Stempelteils (11) und des Matrizenteils (21), mit einem Oberflächenbehandlungsfilm (SF) mit einer Vickershärte von 8.000 Hv oder weniger beschichtet ist, wobei die Arbeitsfläche mit dem Metallmaterial (3) in Kontakt steht;
eine Dicke des Oberflächenbehandlungsfilms (SF) dünner ist als eine Dicke des Diamantfilms (DF); und eine Vickershärte des Diamantfilms (DF) 10.000 bis 12.000 Hv beträgt.

6. Pressbearbeitungsverfahren nach Anspruch 5, wobei
das Metallmaterial (3) unter Einsatz des Stempelteils (11) und des Matrizenteils (21) durch Kühlmittel (LQ) zu einem Dosenkörperteil pressgeformt wird.

7. Pressbearbeitungsverfahren nach Anspruch 5 oder 6, wobei
ein Ölgehalt im Kühlmittel (LQ) gleich oder kleiner als 4,0 Volumenprozent ist.

## Revendications

1. Outil de pressage (100) destinée à l'usinage à la presse d'un matériau métallique (3) à l'aide d'une partie poinçon (11) et d'une partie matrice (21), dans laquelle
une surface d'usinage de l'une parmi la partie poinçon (11) et la partie matrice (21) est revêtue d'un film en diamant (DF) et la surface d'usinage entre en contact avec le matériau métallique (3), **caractérisée en ce que** :
une surface d'usinage de l'autre parmi la partie poinçon (11) et la partie matrice (21) est revêtue d'un film de traitement de surface (SF) présentant une dureté Vickers de 8 000 Hv ou moins, la surface d'usinage entrant en contact avec le matériau métallique (3) ;
une épaisseur du film de traitement de surface (SF) est plus fine qu'une épaisseur du film en diamant (DF) ;
une dureté Vickers du film en diamant (DF) est de 10 000 à 12 000 Hv.

2. Outil de pressage selon la revendication 1, dans laquelle
le film de traitement de surface (SF) est un carbone de type diamant présentant une dureté Vickers de 1 000 à 8 000 Hv.

3. Outil de pressage selon les revendications 1 ou 2, dans laquelle
la partie matrice (21) est revêtue avec le film en diamant (DF) et la partie poinçon (11) est revêtue avec le flm de traitement de surface (SF).

4. Outil de pressage selon l'une quelconque des revendications 1 à 3, dans laquelle
le matériau métallique (3) est un matériau de canette et un usinage consistant à étirer et à repasser destiné à former au moins une partie de corps de canette est réalisé à l'aide de la partie poinçon (11) et de la partie matrice (21).

5. Procédé d'usinage à la presse destiné à usiner à la presse un matériau métallique (3) à l'aide d'une partie poinçon (11) et d'une partie matrice (21), dans lequel
une surface d'usinage de l'une parmi la partie poinçon (11) et la partie matrice (21) est revêtue d'un film en diamant (DF), la surface d'usinage entrant en contact avec le matériau métallique (3), **caractérisé en ce que**
une surface d'usinage de l'autre parmi la partie poinçon (11) et la partie matrice (21) est revêtue d'un film de traitement de surface (SF) présentant une dureté Vickers de 8 000 Hv ou moins, la surface d'usinage entrant en contact avec le matériau métallique (3) ;
une épaisseur du film de traitement de surface (SF) est plus fine qu'une épaisseur du film en diamant (DF) ; et une dureté Vickers du film en diamant (DF) est de 10 000 à 12 000 Hv.

6. Procédé d'usinage à la presse selon la revendication 5, dans lequel
le matériau métallique (3) est usiné à la presse de façon à fabriquer une partie de corps de canette par la partie poinçon (11) et la partie matrice (21) par le biais d'un fluide réfrigérant (LQ).

7. Procédé d'usinage à la presse selon la revendication 5 ou 6, dans lequel
une teneur en huile dans le fluide réfrigérant (LQ) est inférieure ou égale à 4,0 % en volume.
